# EUROPÄISCHE PATENTSCHRIFT

(11) **EP 0 837 115 B1**
(45) Veröffentlichungstag und Bekanntmachung des Hinweises auf die Patenterteilung: **05.01.2000**
(21) Anmeldenummer: 97117891.8
(22) Anmeldetag: 16.10.1997
(51) Int. Cl.: C09K 3/14

(54) **Verfahren zum Abtrennen von Scheiben von einem Kristall**
Method for cutting wafers from a crystal
Procédé pour couper des plaquettes d'un cristal

(30) Priorität: 17.10.1996 DE 19642908
(43) Veröffentlichungstag der Anmeldung: 22.04.1998
(73) Patentinhaber: Wacker Siltronic Gesellschaft für Halbleitermaterialien Aktiengesellschaft, 84489 Burghausen (DE)
(72) Erfinder: Knepprath, Vernon, Damascus, Oregon (US); Frank, Walter, 84508 Burgkirchen / Alz (DE); Kaeser, Maximilian, 84561 Mehring-Öd (DE); Pemwieser, Albert, 5122 Ach (AT)
(74) Vertreter: Rimböck, Karl-Heinz, Dr.

(56) Entgegenhaltungen:
- EP-A- 0 686 684
- EP-A- 0 733 429
- US-A- 2 980 524
- US-A- 3 817 727
- DATABASE WPI Section Ch, Week 9238 Derwent Publications Ltd., London, GB; Class A97, AN 92-312572 XP002050861 & JP 04 218 594 A (NIPPON STEEL CORP) , 10.August 1992
- PATENT ABSTRACTS OF JAPAN vol. 006, no. 090 (C-104), 27.Mai 1982 & JP 57 021495 A (MITSUBISHI METAL CORP), 4.Februar 1982,

## Beschreibung

Gegenstand der Erfindung ist ein Verfahren zum Abtrennen von Scheiben von einem Kristall aus sprödem und hartem Material mit einer Drahtsäge, bei dem ein in Suspensionsform vorliegendes Mittel eingesetzt wird, das aus einer im wesentlichen nichtwässerigen Flüssigkeit besteht, in der abrasiv wirkende Hartstoffteilchen dispergiert sind.

Drahtsägen werden beispielsweise eingesetzt, um Kristalle aus Silicium in dünne Scheiben zu teilen. Als abrasiv wirkendes Mittel kommt dabei eine als Slurry bezeichnete Sägesuspension zum Einsatz, die von den Sägedrähten zum Kristall transportiert wird. Die Sägesuspension besteht aus Hartstoffteilchen, die in einer Flüssigkeit dispergiert sind. Es sind bereits Sägesuspensionen auf Ölbasis und auf wässeriger Basis bekannt geworden.

Aus der EP-686 684 A1 geht hervor, daß es nachteilig ist, ein Öl als Flüssigkeit für die Sägesuspension zu verwenden. Dies wird insbesondere damit begründet, daß die Reinigung ölverschmutzter Teile der Drahtsäge und der Scheiben sehr aufwendig ist. Es wird daher die Verwendung einer Sägesuspension auf wässeriger Basis vorgeschlagen, die wasserlösliche Polymere enthalten soll.

In der US-3,817,727 sind Zusammensetzungen zum Polieren beansprucht, bei denen abrasive Polierpulver in einem Medium suspendiert sind, das Glykol und einen Verdicker enthält.

Gemäß der JP-4218594 reduziert sich bei Verwendung einer wässerigen, bestimmte Glykole und Verdickungsmittel enthaltenden Sägesuspension das Ausmaß der durch den Trennvorgang verursachten, oberflächlichen Beschädigung der Scheiben.

In der US-4,853,140 wird beschrieben, daß die Wahl eines wässerigen Kühlschmiermittels die Form (Geometrie) von Siliciumscheiben günstig beeinflußt, wenn die Siliciumscheiben unter Anwendung des Kühlschmiermittels mit einem Sägeblatt von einem Kristall abgetrennt werden.

Auch bei der Verwendung einer Drahtsäge als Sägewerkzeug ist zu beachten, daß die abgetrennten Scheiben möglichst ebene Seitenflächen besitzen, die darüber hinaus auch parallel zueinander liegen sollten. Abweichungen von dieser idealen Form werden typischerweise dadurch quantifiziert, daß die Dickenvariation (TTV-Wert) und die Durchbiegung (warp-Wert) einer Scheibe gemessen wird.

Die vorliegende Erfindung beruht auf der Erkenntnis, daß bei der Verwendung bekannter Sägesuspensionen
- häufig Scheiben erhalten werden, deren Geometrie unbefriedigend ist,
- sich Krusten aus verfestigtem Material bilden, und damit verschmutzte Scheiben und Drahtsägenteile nur schwer zu reinigen sind, und
- sich bisweilen die Geometrie der erhaltenen Scheiben nach wiederholtem Gebrauch einer Sägesuspension verschlechtert.

Es bestand daher die Aufgabe, ein Verfahren anzugeben, bei dessen Anwendung solche nachteiligen Erscheinungen nicht auftreten.

Gegenstand der Erfindung ist ein Verfahren zum Abtrennen von Scheiben von einem Kristall aus sprödem und hartem Material mit einer Drahtsäge, bei dem ein in Suspensionsform vorliegendes Mittel eingesetzt wird, das aus einer im wesentlichen nichtwässerigen Flüssigkeit besteht, in der abrasiv wirkende Hartstoffteilchen dispergiert sind, das dadurch gekennzeichnet ist, daß die nichtwässerige Flüssigkeit aus einer Gruppe von Verbindungen ausgewählt wird, die Polyglykole mit einem Molekulargewicht von 75 bis 150 und beliebige Mischungen dieser Verbindungen umfaßt, und höchstens bis zu 5 Gew.-% Wasser bezogen auf das Gewicht der Suspension enthält, und von Sägedrähten der Drahtsäge zum Kristall transportiert wird.

Die Erfindung eignet sich insbesondere zum Abtrennen von Scheiben mit großen Durchmessern von mindestens 150 mm. Im Hinblick auf die Geometrie der abgetrennten Scheiben wird bei Anwendung des Verfahrens ein Ergebnis erzielt, das dem Ergebnis zumindest gleichwertig ist, das bei Verwendung auf Öl basierender Sägesuspensionen erreicht wird. Im Vergleich mit der Verwendung wässeriger Sägesuspensionen läßt die Erfindung längere Nutzungsdauern zu. Die Krustenbildung ist erheblich reduziert. Reste der Sägesuspension lassen sich ohne besonderen Aufwand mit Wasser entfernen. Ferner zeichnet sich das Verfahren durch eine gute Umweltverträglichkeit aus, da die flüssigen Bestandteile der Suspension nicht toxisch und biologisch abbaubar sind.

Es hat sich herausgestellt, daß sich wässerige Sägesuspensionen nur über vergleichsweise kurze Zeiträume zum Gebrauch eignen, weil sie während ihres Einsatzes rasch Wasser verlieren und sich Hartstoffteilchen absetzen. Beim Sägen von Kristallen aus Silicium wird dieser Wasserverlust beschleunigt, weil zerspantes Silicium Wasser unter Wärmeentwicklung in Wasserstoff und Sauerstoff spaltet. In der Folge wird auch Siliciumdioxid gebildet, das mit sich absetzenden Hartstoffteilchen verkrustet. Durch die Gasentwicklung setzt darüber hinaus eine störende Schaumbildung ein. Diese Umstände bewirken letztlich, daß die Geometrie von abgetrennten Scheiben bereits nach vergleichsweise kurzer Nutzungsdauer der wässerigen Sägesuspension den Anforderungen nicht mehr genügt.

Deshalb ist für einen längeren, erfolgreichen Einsatz des Verfahrens die Abwesenheit von Wasser besonders wichtig. Allerdings kann eine geringe Menge von bis zu 5 Gew.-% Wasser bezogen auf das Gewicht der Sägesuspension toleriert werden, beispielsweise, wenn die Anwesenheit von Wasser auf die hygroskopische Natur der Flüssigkeit zurückzuführen ist, die zur Herstellung der Sägesuspension verwendet wird. Erfindungsgemäß wird eine nichtwässerige Flüssigkeit verwendet, die aus einer Gruppe von Verbindungen ausgewählt wird, die niedermolekulare Polyglykole und beliebige Mischungen dieser Verbindungen umfaßt, wobei die Viskosität der Flüssigkeit vorzugsweise 50 bis 800 mPa*s bei 20°C ist. Das Molekulargewicht der Verbindungen liegt im Bereich von 75 bis 150. Bevorzugt sind Propylenglykol, Dipropylenglykol, Triethylenglykol und niedermolekulare Polyethylenglykole und Mischungen der genannten Verbindungen. Besonders bevorzugt ist Dipropylenglykol.

Zur Herstellung der Sägesuspension werden die Hartstoffteilchen in der Flüssigkeit dispergiert, wobei bevorzugt die in der EP-686 684 A1 genannten Hartstoffe verwendet werden. Ein besonders bevorzugter Hartstoff ist Siliciumcarbid.

Die im Verfahren eingesetzte Sägesuspension kann nach einer bestimmten Anzahl von Sägeoperationen ausgetauscht werden. Ebenso ist es möglich, zunächst in regelmäßigen Abständen nur einen Teil der Sägesuspension zu erneuern. Es ist weiterhin bevorzugt, eine gebrauchte Sägesuspension aufzuarbeiten und die Hartstoffe von der Flüssigkeit zu trennen. Die Hartstoffe können gegebenenfalls wiederverwendet werden. Bei der Entsorgung der Flüssigkeit wird vorzugsweise deren biologische Abbaubarkeit genutzt.

## Patentansprüche

1. Verfahren zum Abtrennen von Scheiben von einem Kristall aus sprödem und hartem Material mit einer Drahtsäge, bei dem ein in Suspensionsform vorliegendes Mittel eingesetzt wird, das aus einer im wesentlichen nichtwässerigen Flüssigkeit besteht, in der abrasiv wirkende Hartstoffteilchen dispergiert sind, dadurch gekennzeichnet, daß die nichtwässerige Flüssigkeit aus einer Gruppe von Verbindungen ausgewählt wird, die Polyglykole mit einem Molekulargewicht von 75 bis 150 und beliebige Mischungen dieser Verbindungen umfaßt, und höchstens bis zu 5 Gew.-% Wasser bezogen auf das Gewicht der Suspension enthält, und von Sägedrähten der Drahtsäge zum Kristall transportiert wird.

2. Verfahren nach Anspruch 1, dadurch gekennzeichnet, daß die nichtwässerige Flüssigkeit aus einer Gruppe von Verbindungen ausgewählt wird, die Propylenglykol, Dipropylenglykol, Triethylenglykol und niedermolekulare Polyethylenglykole und Mischungen der genannten Verbindungen umfaßt.

3. Verfahren nach Anspruch 1 oder Anspruch 2, dadurch gekennzeichnet, daß die nichtwässerige Flüssigkeit eine Viskosität von 50 bis 800 mPa*s bei 20°C besitzt.

## Claims

1. Method for cutting wafers from a crystal of brittle and hard material using a wire saw, in which use is made of an agent which is in suspension form and consists of an essentially nonaqueous liquid in which hard-material particles with abrasive action are dispersed, characterized in that the nonaqueous liquid is selected from a group of compounds which comprises polyglycols with a molecular weight of from 75 to 150 and any desired mixtures of these compounds, and contains at most up to 5% by weight of water relative to the weight of the suspension, and is transferred by the saw wires of the wire saw to the crystal.

2. Method according to Claim 1, characterized in that the nonaqueous liquid is selected from a group of compounds which comprises propylene glycol, dipropylene glycol, triethylene glycol and low-molecular-weight polyethylene glycols and mixtures of the said compounds.

3. Method according to Claim 1 or 2, characterized in that the nonaqueous liquid has a viscosity of 50 to 800 mPa·s at 20°C.

## Revendications

1. Procédé pour séparer des plaquettes d'un cristal de matériau cassant et dur avec une scie à fils métalliques, au cours duquel on utilise un moyen présent sous forme de suspension, constitué d'un liquide essentiellement non aqueux, dans lequel des particules de substance dure agissant de manière abrasive sont dispersées, caractérisé en ce que le liquide non aqueux est sélectionné parmi un groupe de composés, qui comprend des polyglycols d'un poids moléculaire de 75 à 150 et des mélanges quelconques de ces composés, et contient tout au plus jusqu'à 5% en poids d'eau sur base du poids de la suspension, et est transporté des fils métalliques de la scie à fils métalliques au cristal.

2. Procédé suivant la revendication 1, caractérisé en ce que le liquide non aqueux est sélectionné parmi un groupe de composés, qui comprend du propylèneglycol, du dipropylèneglycol, du triéthylèneglycol et des polyéthylèneglycols de faible poids moléculaire et des mélanges des composés cités.

3. Procédé suivant la revendication 1 ou la revendication 2, caractérisé en ce que le liquide non aqueux possède une viscosité de 50 à 800 mPa.s à 20°C.
